# EUROPEAN PATENT APPLICATION

(11) **EP 3 998 599 A1**
(43) Date of publication of application: **18.05.2022**
(21) Application number: 20904263.9
(22) Date of filing: 14.05.2020
(51) Int. Cl.: G09G 3/3233, H01L 23/544

(54) **DISPLAY PANEL AND MANUFACTURING METHOD THEREFOR**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: SHI, Ling, Beijing 100176 (CN); HUANG, Chienpang, Beijing 100176 (CN); ZHANG, Hao, Beijing 100176 (CN)
(74) Representative: Maiwald Patent- und Rechtsanwaltsgesellschaft mbH
(86) International application number: PCT/CN2020/090192
(87) International publication number: WO 2021/226920

(57) **Abstract**

A display panel and a manufacturing method thereof are provided. The display panel has a display side and a non-display side, and includes a display region (AA) and a bending region (B) located on a side edge of the display region (AA), the bending region (B) includes at least one first wire (101), and the bending region (B) is capable of being operatively bent from the display side to the non-display side, the display region (AA) includes a second wire (102), a first end (1011) of the first wire (101) is electrically connected to the second wire (102), and a second end (1012) of the first wire (101) is bent to the non-display side through the bending region (B). The bending region (B) further includes a detection wire (103) arranged side by side with the first wire (101), at least a part of the detection wire (103) is bent along with the bending region (B), and the detection wire (103) includes a first end (1031) and a second end (1032), which are used to connect an external detection circuit; and the detection wire (103) and the bending region (B) are only located on a side of the side edge away from the display region (AA). The detection wire (103) is detected by the external detection circuit, and a state of the first wire (101) arranged side by side with the detection wire (103) in the bending region (B) can be determined.

## Description

### TECHNICAL FIELD

Embodiments of the present disclosure relate to a display panel and a manufacturing method thereof.

### BACKGROUND

OLED (Organic Light Emitting Diode) display panels have a series of advantages such as self-luminescence, high contrast, high definition, wide viewing angle, low power consumption, fast response speed, and compatibility of manufacturing process with a thin film transistor (TFT) process, have become one of the key development directions of a new generation of display devices, and therefore have attracted more and more attention. At present, the OLED display panels are developing towards larger screens and full screens to improve user experience.

### SUMMARY

At least one embodiment of the present disclosure provides a display panel, the display panel has a display side and a non-display side, and comprises a display region and a bending region located on a side edge of the display region, the bending region comprises at least one first wire, and the bending region is capable of being operatively bent from the display side to the non-display side, the display region comprises a second wire, a first end of the at least one first wire is electrically connected to the second wire, and a second end of the at least one first wire is bent to the non-display side through the bending region; the bending region further comprises a detection wire arranged side by side with the at least one first wire, at least a part of the detection wire is bent along with the bending region, and the detection wire comprises a first end and a second end, which are used to connect an external detection circuit; and the detection wire and the bending region are only located on a side of the side edge away from the display region.

For example, in the display panel provided by at least one embodiment of the present disclosure, the at least one first wire comprises a plurality of first wires, and the plurality of first wires comprise a first group of wires and a second group of wires, the first group of wires and the second group of wires are insulated from each other and are configured to transmit different electrical signals, respectively, the detection wire is arranged between the first group of wires and the second group of wires.

For example, in the display panel provided by at least one embodiment of the present disclosure, the first group of wires are power wires, and the second group of wires are data wires; or the first group of wires and the second group of wires are power wires that transmit different potentials.

For example, in the display panel provided by at least one embodiment of the present disclosure, a shape and a size of the first wire per unit length are substantially identical to a shape and a size of the detection wire per unit length.

For example, in the display panel provided by at least one embodiment of the present disclosure, both the first wire and the detection wire extend in a curved shape or have a hollow structure.

For example, in the display panel provided by at least one embodiment of the present disclosure, the detection wire is arranged in a plurality of rows that are electrically connected in an end-to-end manner in sequence, and the first end and the second end of the detection wire are respectively located in a first row and a last row of the plurality of rows.

For example, in the display panel provided by at least one embodiment of the present disclosure, after the bending region is bent, the first end and the second end of the detection wire are both located on the non-display side.

For example, in the display panel provided by at least one embodiment of the present disclosure, in the bending region, a sum of a count of first wires and a count of the rows of the detection wire is less than or equal to 500, a first interval distance between two adjacent rows of the detection wire is 10~12 microns, and a sum of a line width of the detection wire and the first interval distance is 60~80 microns; or a sum of a count of first wires and a count of the rows of the detection wire is greater than 500 and is less than or equal to 2000, a first interval distance between two adjacent rows of the detection wire is 6~10 microns, and a sum of a line width of the detection wire and the first interval distance is 25~60 microns; or a sum of a count of first wires and a count of the rows of the detection wire is greater than 2000, a first interval distance between two adjacent rows of the detection wire is 5~6 microns, and a sum of a line width of the detection wire and the first interval distance is 15~25 microns.

For example, in the display panel provided by at least one embodiment of the present disclosure, a second interval distance between two adjacent first wires is identical to the first interval distance, and a sum of a line width of the first wire and the second interval distance is identical to the sum of the line width of the detection wire and the first interval distance.

For example, in the display panel provided by at least one embodiment of the present disclosure, in a direction perpendicular to a surface of the display panel, a thickness of the first wire and a thickness of the detection wire are identical, and the thickness is 700 nm~850 nm.

For example, in the display panel provided by at least one embodiment of the present disclosure, the detection wire and at least part of the plurality of first wires are arranged in a same layer.

For example, in the display panel provided by at least one embodiment of the present disclosure, the display region comprises a plurality of sub-pixels arranged in an array, each of the plurality of sub-pixels comprises a light emitting device and a pixel drive circuit electrically connected to the light emitting device, the pixel drive circuit comprises a thin film transistor, and the thin film transistor comprises a gate electrode and source-drain electrodes, the detection wire is arranged in a same layer as the gate electrode or arranged in a same layer as the source-drain electrodes.

At least one embodiment of the present disclosure provides a manufacturing method of a display panel, the display panel has a display side and a non-display side, the method comprises: forming a display region and a bending region located on a side edge of the display region, in which at least one first wire and a detection wire arranged side by side with the at least one first wire are formed in the bending region, the detection wire comprises a first end and a second end, which are used to connect an external detection circuit, the detection wire and the bending region are only formed on a side of the side edge away from the display region; a second wire is formed in the display region, and a first end of the at least one first wire is electrically connected to the second wire; and bending the bending region, so that a second end of the at least one first wire is bent to the non-display side through the bending region, and at least a part of the detection wire is bent along with the bending region.

For example, the manufacturing method of a display panel provided by at least one embodiment of the present disclosure further comprises: after bending the bending region, connecting the first end and the second end of the detection wire to the external detection circuit, the external detection circuit detecting a resistance of the detection wire and comparing the resistance with a reference resistance to determine a state of the detection wire.

For example, in the manufacturing method of a display panel provided by at least one embodiment of the present disclosure, in a case where a difference between the resistance and the reference resistance is greater than ten percent of the reference resistance, it is determined that the detection wire is in a damaged state; and in a case where the difference between the resistance and the reference resistance is less than or equal to ten percent of the reference resistance, it is determined that the detection wire is in a normal state.

For example, in the manufacturing method of a display panel provided by at least one embodiment of the present disclosure, the at least one first wire comprises a plurality of first wires, and the plurality of first wires comprise a first group of wires and a second group of wires, the first group of wires and the second group of wires are insulated from each other and are configured to transmit different electrical signals, respectively, the detection wire is formed between the first group of wires and the second group of wires.

For example, in the manufacturing method of a display panel provided by at least one embodiment of the present disclosure, the detection wire and at least part of the plurality of first wires are formed in a same layer.

For example, in the manufacturing method of a display panel provided by at least one embodiment of the present disclosure, forming the display region further comprises forming a plurality of sub-pixels arranged in an array, each of the plurality of sub-pixels comprising a light emitting device and a pixel drive circuit electrically connected to the light emitting device, the pixel drive circuit comprising a thin film transistor, and the thin film transistor comprising a gate electrode and source-drain electrodes, the detection wire is formed in a same layer as the gate electrode or formed in a same layer as the source-drain electrodes.

### BRIEF DESCRIPTION OF THE DRAWINGS

In order to demonstrate clearly technical solutions of the embodiments of the present disclosure, the accompanying drawings in relevant embodiments of the present disclosure will be introduced briefly. It is apparent that the drawings may only relate to some embodiments of the disclosure and not intended to limit the present disclosure.
FIG. 1 is a schematic partial plan view of a display panel provided by at least one embodiment of the present disclosure;
FIG. 2 is a schematic cross-sectional view of a display panel provided by at least one embodiment of the present disclosure;
FIG. 3Ais a schematic plan view of a bending region of a display panel provided by at least one embodiment of the present disclosure;
FIG. 3B is a schematic plan view of a wire arrangement in a bending region of a display panel provided by at least one embodiment of the present disclosure;
FIG. 4 is a schematic plan view of a bending region of another display panel provided by at least one embodiment of the present disclosure;
FIG. 5 is a schematic plan view of a detection wire in a bending region of a display panel provided by at least one embodiment of the present disclosure;
FIGS. 6A-6D are schematic diagrams of a detection wire per unit length in a bending region of a display panel provided by at least one embodiment of the present disclosure;
FIG. 7 is a schematic diagram of first wires and a detection wire in a bending region of a display panel provided by at least one embodiment of the present disclosure;
FIG. 8 is a schematic cross-sectional view of a display region of a display panel provided by at least one embodiment of the present disclosure;
FIG. 9 is a schematic cross-sectional view of a bending region of a display panel provided by at least one embodiment of the present disclosure;
FIG. 10 is a flowchart of a manufacturing method of a display panel provided by at least one embodiment of the present disclosure; and
FIG. 11 is a flowchart of another manufacturing method of a display panel provided by at least one embodiment of the present disclosure.

### DETAILED DESCRIPTION

In order to make objects, technical solutions and advantages of the embodiments of the disclosure apparent, the technical solutions of the embodiment will be described in a clearly and fully understandable way in connection with the drawings related to the embodiments of the disclosure. It is apparent that the described embodiments are just a part but not all of the embodiments of the disclosure. Based on the described embodiments herein, those skilled in the art may obtain other embodiment, without any creative work, which shall be within the scope of the disclosure.

Unless otherwise defined, all the technical and scientific terms used herein have the same meanings as commonly understood by one of ordinary skill in the art to which the present disclosure belongs. The terms, such as "first," "second," or the like, which are used in the description and the claims of the present disclosure, are not intended to indicate any sequence, amount or importance, but for distinguishing various components. The terms, such as "comprise/comprising," "comprise/comprising," or the like are intended to specify that the elements or the objects stated before these terms encompass the elements or the objects and equivalents thereof listed after these terms, but not preclude other elements or objects. The terms, such as "connect/connecting/connected," "couple/coupling/coupled" or the like, are not limited to a physical connection or mechanical connection, but may comprise an electrical connection/coupling, directly or indirectly. The terms, "on," "under," "left, " "right, " or the like are only used to indicate relative position relationship, and when the position of the object which is described is changed, the relative position relationship may be changed accordingly.

In a process of the development of a display panel towards a direction of large-screen and full-screen, how to further increase a screen ratio (that is, the ratio of a display region on a display side of the display panel) of the display panel is a main research problem for those skilled in the art. In some embodiments, by disposing a bendable region on one side of the display region of the display panel, a non-display region of the display panel can be bent to a non-display side of the display panel through the bendable region to increase the ratio of the display region on the display side of the display panel. Generally speaking, the bendable region includes a plurality of wires that electrically connect the display region and a display panel driving chip. These wires have the risk of breaking during the bending process of the bendable region. If the wires are broken, the display panel cannot work normally.

At least one embodiment of the present disclosure provides a display panel and a manufacturing method thereof. The display panel has a display side and a non-display side, and comprises a display region and a bending region located on a side edge of the display region, the bending region comprises at least one first wire, the bending region can be operatively bent from the display side to the non-display side, the display region comprises a second wire, a first end of the at least one first wire is electrically connected to the second wire, and a second end of the at least one first wire is bent to the non-display side through the bending region. The bending region further comprises a detection wire arranged side by side with the at least one first wire, at least a part of the detection wire is bent along with the bending region, and the detection wire comprises a first end and a second end, which are used to connect an external detection circuit; and the detection wire and the bending region are only located on a side of the side edge away from the display region. After the bending region is bent, by detecting the detection wire in the bending region of the display panel, a state of the detection wire can be obtained, and it can be judged whether the detection wire remains in a normal state after being bent, and therefore the state of the wire used for transmitting a display signal to the display region in the bending region can be determined, which provides help for the structure design and manufacturing process of the bending region.

Hereinafter, the display panel and the manufacturing method thereof provided by the embodiments of the present disclosure are introduced in detail and without limitation through several specific embodiments.

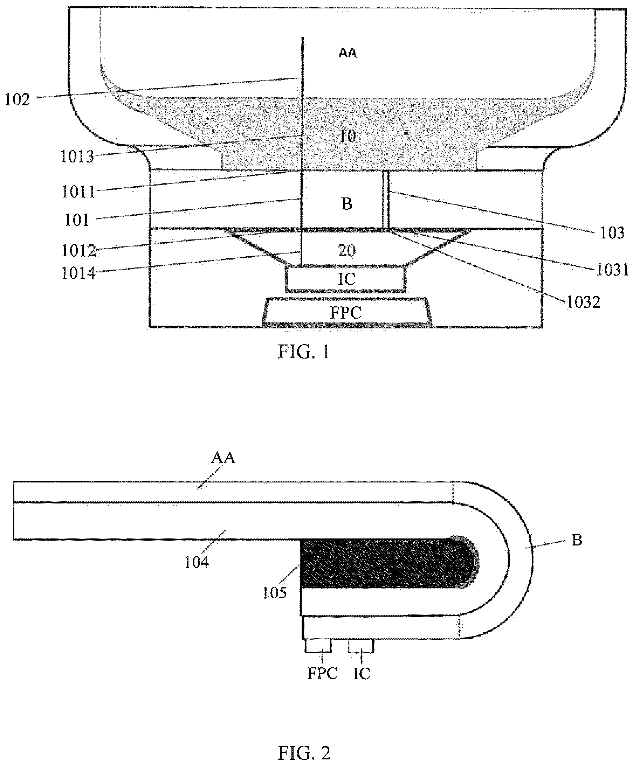

FIG. 1 shows a schematic partial plan view of a display panel provided by at least one embodiment of the present disclosure; and FIG. 2 shows a schematic cross-sectional view of the display panel after being bent.

As shown in FIG. 1 and FIG. 2, the display panel has a display side (that is, the upper side of the display panel shown in FIG. 2) and a non-display side (that is, the lower side of the display panel shown in FIG. 2), and includes a display region AA and a bending region B located on a side edge (for example, the lower side edge in FIG. 2) of the display region AA, and the bending region B includes at least one first wire 101 (one first wire 101 is shown in FIG. 1 as an example), as shown in FIG. 2, the bending region B can be operatively bent from the display side to the non-display side, that is, after the bending region B is bent, the structure in the bending region B can be bent and deformed adaptively and can remain in a workable state, and for example, can achieve the required electrical connection or signal transmission. The display region AA includes one or more second wires 102 (one second wire 102 is shown in FIG. 1 as an example), a first end 1011 of the at least one first wire 101 is electrically connected to a second wire 102 corresponding thereto, and a second end 1012 of the at least one first wire 101 is bent to the non-display side through the bending region B. The bending region B includes a detection wire 103 arranged side by side with the at least one first wire 101, for example, the at least one first wire 101 and the detection wire 103 are arranged side by side along a bending axis of the bending region B (a length direction of the bending region B in the figure, that is, a horizontal direction), at least a part of the detection wire 103 is bent along with the bending region B. The detection wire 103 includes a first end 1031 and a second end 1032, which are used to connect an external detection circuit. For example, the detection wire 103 and the bending region B are only located on a side of the aforementioned side edge away from the display region AA

It should be noted that in the embodiments of the present disclosure, the detection wire 103 and the bending region B are only located on a side of the display region AA, for example, the detection wire 103 does not surround the display region AA

For example, in some embodiments, the display region AA includes a plurality of second wires 102, and the bending region B includes a plurality of first wires 101, the first ends of the plurality of first wires 101 are respectively electrically connected to the plurality of second wires 102, and the second ends of the plurality of first wires 101 are bent to the non-display side through the bending region B, so that electrical signals can be provided to the plurality of second wires 102 in the display region AA through the plurality of first wires 101 in the non-display side.

In the embodiments of the present disclosure, by detecting the detection wire 103 in the bending region B of the display panel, a state of the detection wire 103 can be obtained, and then it can be judged whether the detection wire 103 is normal after being bent, so that it can be inferred that the state of the first wire 101 that is arranged side by side with the detection wire 103 in the bending region B and is used to transmit electrical signals for the display region AA. For example, in some examples, resistance detection can be performed on the detection wire 103, in a case where a detected resistance value of the detection wire 103 is greater than a reference resistance, it can be determined that the detection wire 103 is abnormal, for example, the detection wire 103 has a significant crack or break, and therefore it is inferred that the first wire 101, which is arranged side by side with the detection wire 103 in the bending region B and is used to transmit electrical signals for the display region AA, is likely to be abnormal, in this case, the structural design and the manufacturing process of the bending region B need to be optimized; for example, in a case where the detected resistance value of the detection wire 103 is less than the reference resistance, it can be determined that the detection wire 103 is normal, and therefore it is inferred that the first wire 101, which is arranged side by side with the detection wire 103 in the bending region B and is used to transmit electrical signals for the display region AA, can also work normally, in this case, the structure design of the bending region B is reasonable and the production is qualified. For example, the aforementioned reference resistance is an average resistance measured when the detection wire 103 is in a normal state.

For example, in some embodiments, as shown in FIG. 1, the display panel further includes a driving chip IC (Integrated Circuit) for driving the display region AA to perform a display operation, the second end 1012 of the first wire 101 is electrically connected to the driving chip IC to electrically connect the second wire 102 in the display region AA with the driving chip IC, and therefore the electrical signals, such as display signals, control signals, timing signals, etc., are provided to the display region AA through the first wire 101. For example, after the bending region B is bent, the driving chip IC is bent to the non-display side of the display panel.

For example, in some embodiments, the display panel may further include a flexible printed circuit (FPC), and the second end 1012 of the first wire 101 may also be electrically connected to the flexible printed circuit, for example, by bonding. For example, in some examples, the flexible circuit board FPC may further include a drive circuit, and the second end 1012 of the first wire 101 is electrically connected to the drive circuit, and the drive circuit transmits electrical signals, such as touch signals or clock signals, to the display region AA through the first wire 101. For example, after the bending region B is bent, the flexible circuit board FPC is bent to the non-display side of the display panel, and overlaps with the display region, thereby helping to achieve a narrow frame design.

Thus, the driving chip IC or the flexible circuit board FPC is disposed on the non-display side of the display panel, and the plurality of first wires 101 electrically connect the plurality of second wires 102 in the display region AA to the driving chip IC or the flexible circuit board FPC on the non-display side of the display panel through bending.

For example, in some embodiments, as shown in FIG. 1, the display panel may further include a first fan-shaped wire region 10 located between the display region AA and the bending region B, the first fan-shaped wire region 10 includes a plurality of first leads 1013 (one first lead is shown as an example in the figure), which are used to electrically connect the plurality of second wires 102 in the display region AA to the first ends 1011 of the plurality of first wires 101 in the bending region B. For example, the display panel may further include a second fan-shaped wire region 20 between the bending region B and the driving chip IC or the flexible circuit board FPC, and the second fan-shaped wire region 20 includes a plurality of second leads 1014 (one second lead is shown as an example in the figure), which are used to electrically connect the second ends 1012 of the plurality of first wires 101 in the bending region B to the driving chip IC or the flexible circuit board FPC.

For example, as shown in FIG. 2, the non-display side of the display panel may also include structures such as a back film 104. After the bending region B is bent, an adhesive 105 can be used to bond the back film 104 in a bending portion of the display panel to fix a bending state of the bending region B. The back film 104 can protect the display panel.

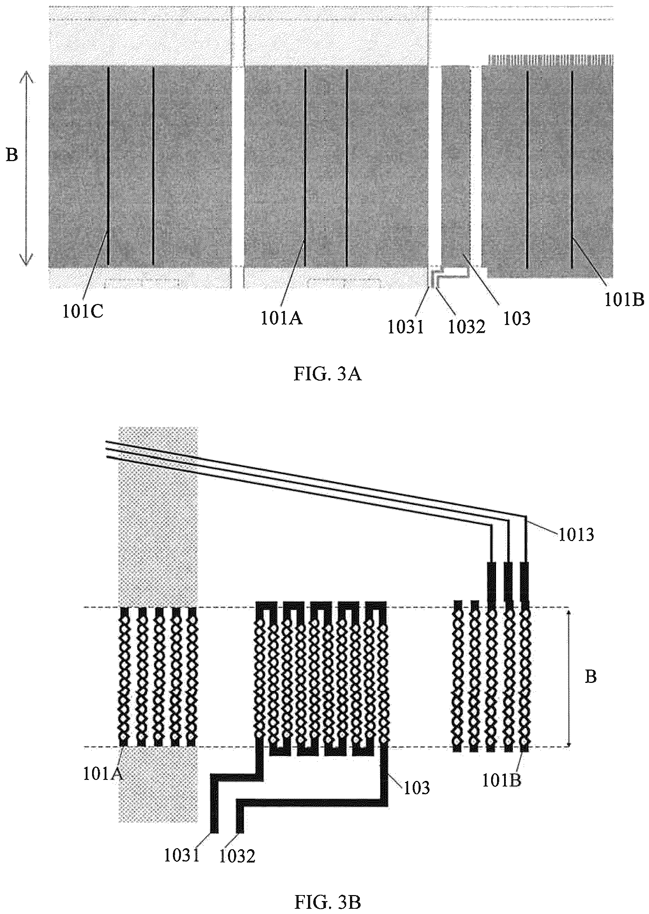

For example, in some embodiments, the plurality of first wires 101 in the bending region B include a plurality of groups of wires for transmitting different electrical signals. For example, as shown in FIG. 3A, in the bending region B, the plurality of first wires 101 include a first group of wires 101A and a second group of wires 101B, the first group of wires 101A and the second group of wires 101B are insulated from each other and are configured to transmit different electrical signals, respectively, and the detection wire 103 is arranged between the first group of wires 101A and the second group of wires 101B. Therefore, the detection wire 103 separates the first group of wires 101A and the second group of wires 101B, which are used for respectively transmitting different electrical signals, thereby avoiding signal crosstalk between the first group of wires 101A and the second group of wires 101B, and furthermore preventing the plurality of first wires 101 from causing heat concentration due to transmitting excessive current.

For example, in some embodiments, the first group of wires 101A are power lines, such as power lines VDD for transmitting high potentials or power lines VSS for transmitting low potentials, and the second group of wires 101B are data lines DATA used to transmit data signals for the display region AA; or, in some embodiments, the first group of wires 101A and the second group of wires 101B are power lines that transmit different potentials, for example, the first group of wires 101A are power lines VDD for transmitting high potentials, and the second group of wires 101B are power lines VSS for transmitting low potentials. In other embodiments, the first group of wires 101A and the second group of wires 101B may also be wires that transmit other signals, for example, may be scan lines that transmit scan signals.

For example, in an example, as shown in FIG. 3A, the plurality of first wires 101 in the bending region B include a first group of wires 101A, a second group of wires 101B, and a third group of wires 101C, the first group of wires 101A are power lines VDD used to transmit high potentials, the second group of wires 101B are data lines DATA used to transmit data signals for the display region AA, and the third group of wires 101C are power lines VSS used to transmit low potentials, the detection wire 103 is arranged between the first group of wires 101A and the second group of wires 101B to prevent signal crosstalk between the power line VDD and the data line DATA. For example, in another example, the detection wire 103 may also be arranged between the second group of wires 101B and the third group of wires 101C to prevent signal crosstalk between the power line VDD and the power line VSS; alternatively, the detection wires 103 are disposed between the first group of wires 101A and the second group of wiring 101B, and also disposed between the second group of wires 101B and the third group of wires 101C, to prevent signal crosstalk between different wires and prevent heat concentration due to transmitting excessive current.

It should be noted that different gray regions in FIG. 3A represent the regions where a plurality of groups of wires are arranged in the bending region B, each gray region includes a plurality of wires (two wires are shown as an example in the figure), for example, these wires are arranged side by side. For example, in a case where the first group of wires 101A are power lines VDD for transmitting high potentials, a plurality of wires of the first group of wires 101A are arranged side by side in the above region and are electrically connected with each other at at least one end (for example, electrically connected with each other in light gray regions above and/or below the gray region in FIG. 3A, for example, so as to be connected as a whole), so as to transmit electrical signals of the same potential. Similarly, the power lines VSS can also be arranged similarly.

For example, in an example, FIG. 3B shows a schematic diagram of an arrangement of the detection wire 103 and the first group of wires 101A and the second group of wires 101B on both sides of the detection wire. As shown in FIG. 3B, the first group of wires 101A are power lines, and the plurality of wires of the first group of wires 101A are connected as a whole at the upper end of FIG. 3B (the light gray part in the figure), and are used to transmit the electrical signals of the same potential. The second group of wires 101B are data lines DATA, and the plurality of data lines DATA are connected to the drive circuit in the display region AA through the plurality of first leads 1013 in the first fan-shaped wire region 10, respectively. For example, the first group of wires 101A, the second group of wires 101B, and the plurality of first leads 1013 in the first fan-shaped wire region 10 define a space, and the detection wire 103 can be arranged in the space.

For example, in some embodiments, the plurality of groups of wires included in the plurality of first wires 101 in the bending region B are symmetrically distributed, for example, are distributed axially symmetrically with respect to a center line of a length direction of the bending region B (for example, the horizontal direction in FIG. 1), in this case, the center line extends from a side of the bending region B close to the display region AA to a side of the bending region B away from the display region AA, and the extension direction of the center line is the same as the extension direction of the plurality of first wires 101.

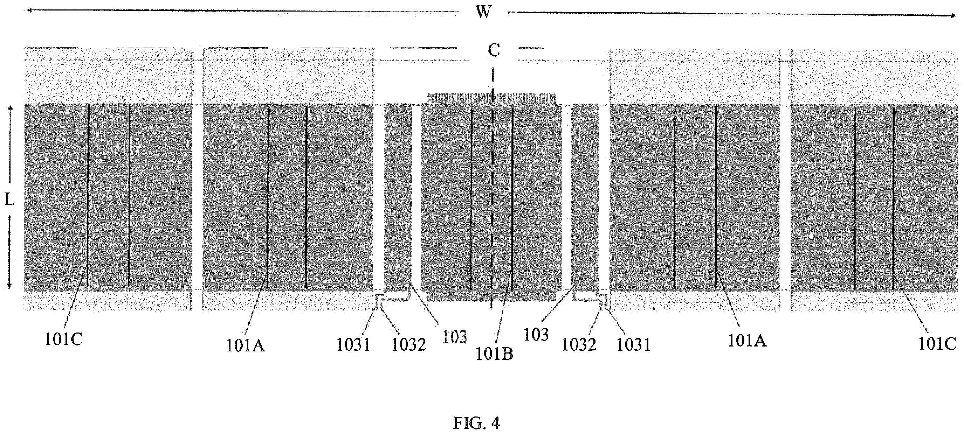

For example, in an example, as shown in FIG. 4, the plurality of first wires 101 in the bending region B includes a second group of wires 101B located in the center, two first groups of wires 101B respectively located on both sides of the second group of wires 101B, and two third groups of wires 101C respectively located on sides of the two first groups of wires 101B away from the second group of wires 101B. The center line C of the bending region B is located in the middle of the second group of wires 101B, and the plurality of groups of wires included in the plurality of first wires 101 are distributed axially symmetrically with respect to the center line C. For example, the second group of wires 101B located in the center position are power lines VDD used to transmit high potentials, the two first groups of wires 101A are data lines DATA used to transmit data signals for the display region AA, the two third groups of wires 101C are power lines VSS used to transmit low potentials, and the detection wire 103 is provided between the first group of wires 101A and each second group of wires 101B. For example, in other examples, the detection wire 103 may be provided between each second group of wires 101B and the third group of wires 101C that is adjacent to each second group of wires 101B; or, the detection wire 103 is provided between the first group of wires 101A and each second group of wires 101B, and the detection wire 103 is also provided between each second group of wires 101B and the third group of wires 101C that is adjacent to each second group of wires 101B.

For example, in some embodiments, the plurality of first wires 101 in the bending region B may further comprise two fourth groups of wires (not shown) respectively located on sides of the two third groups of wires 101C away from the second group of wires 101B, etc., for example, the fourth group of wires are clock signal lines. The embodiments of the present disclosure do not specifically limit the type and quantity of the transmission signals of respective wires in the bending region B. For example, the detection wire may also be disposed on one side of the clock signal lines, for example, disposed between the third group of wires 101C and the fourth group of wires, or disposed on a side of the fourth group of wires away from the third group of wires 101C.

For example, in some embodiments, the data lines DATA, the clock lines, the power lines, or the like in the bending region B have a thinner line width, so that the detection wire is designed to have the same material, line width, and structure as these lines, and are disposed on a side of these lines, thereby effectively detect the states of these lines, such as whether these lines are broken. For example, in some embodiments, the data lines DATA, the clock lines, the power lines, or the like in the bending region B may also have different line widths, in this case, the detection wire can be disposed next to a wire with a thinner line width, and designed to have the same material, line width, and structure as the wire with a thinner line width, so as to accurately detect the state of the wire with a thinner line width.

For example, in some embodiments, after the bending region B is bent, the first end 1031 and the second end 1032 of the detection wire 103 are both located on the non-display side of the display panel. For example, in the embodiment shown in FIG. 3A and FIG. 4, the first end 1031 and the second end 1032 of the detection wire 103 are both located on the side of the bending region B that is bent to the non-display side (i.e., the lower side shown in the figure). Therefore, the detection wire 103 can be electrically connected to an external detection circuit on the non-display side of the display panel for detection, thereby avoiding the effect of detection on the display side on the structure and circuit of the display panel.

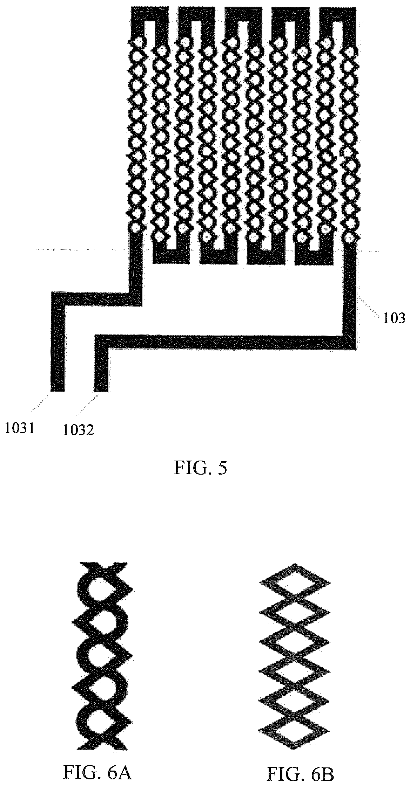

For example, in some embodiments, the detection wire 103 is arranged in a plurality of rows that are electrically connected in an end-to-end manner in sequence, and the first end 1031 and the second end 1032 of the detection wire 103 are respectively in a first row and a last row of the plurality of rows. For example, FIG. 5 shows a schematic diagram of the arrangement of the detection wire 103. As shown in FIG. 5, the detection wire 103 includes a plurality of rows that are electrically connected in an end-to-end manner in sequence (the figure shows ten rows as an example), and the first end 1031 and the second end 1032 of the detection wire 103 are respectively led from a first row (the leftmost row in the figure) and a last row (the rightmost row in the figure) of the plurality of rows. In this case, when the detection wire 103 is detected through the first end 1031 and the second end 1032, if an abnormality, such as a break, occurs in any one part of the plurality of rows after being bent, a detection result of the detection wire 103 will be abnormal, for example, the detected resistance value of the detection wire 103 becomes larger, and it can be inferred that the first wire 101 arranged side by side with the detection wire 103 is likely to be abnormal; in addition, the detection wire 103 is arranged in the plurality of rows electrically connected in an end-to-end manner in sequence, which can improve the accuracy of detection and reduce the fortuity of detection.

For example, in some embodiments, a shape and a size of the first wire 101 per unit length are substantially identical to a shape and a size of the detection wire per unit length 103. For example, in some embodiments, the first wire 101 and the detection wire 103 both extend from one side of the bending region B (for example, the side close to the display region AA) to the other side of the bending region B (for example, the side close to the driving chip IC) in the same direction. Therefore, the structure and arrangement of the first wire 101 and the structure and arrangement of the detection wire 103 are basically the same, thereby improving the accuracy of determining the state of the first wire 101 based on the detection result of the detection wire 103.

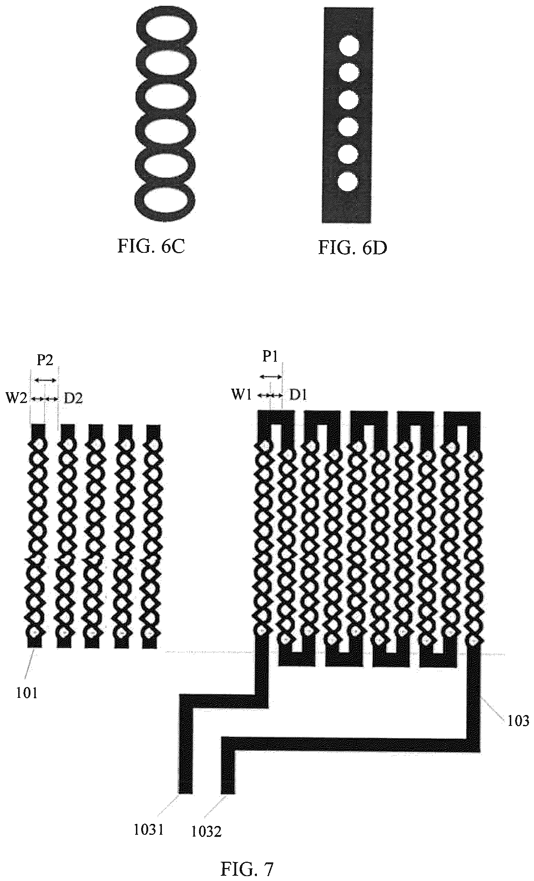

For example, in some embodiments, both the first wire 101 and the detection wire 103 extend in a curved shape or have a hollow structure. For example, as shown in FIGS. 6A to 6D, the first wire 101 and the detection wire 103 may extend in a zigzag shape, in an arc-shaped shape, or have a hollow structure, so that after the bending region B is bent, the first wire 101 and the detection wire 103 can adapt to the shape change of the bending region B by changing the wire shape (for example, elongation), so as to prevent the first wire 101 and the detection wire 103 from being broken after the bending region B is bent.

For example, in some embodiments, the size and arrangement of the first wire 101 and the size and arrangement of the detection wire 103 may be designed according to the size of the bending region B, the number(count) of the first wires 101, and the number of rows of the detection wire 103. For example, in some examples, as shown in FIG. 4, the length L of the bending region B may be 1.3 mm~2.0 mm, and the width W of the bending region B may be designed according to the type of product, for example, for products having a small size, such as watches, the width W of the bending region B may be 15mm~20mm; for products having a medium size such as mobile phones, the width W of the bending region B may be 45mm~60mm; and for products having a large size such as tablet computers, the width W of the bending region B may be 130 mm ~160 mm. For example, the bending radius of the bending region B (that is, the radius of the arc formed by the bending region B after being bent) may be 0.2 mm~0.5 mm. In this case, in the bending region B, as shown in FIG. 7, in a case where the sum of the number(count) of the first wires 101 and the number of rows of the detection wire 103 is less than or equal to 500, the first interval distance D1 between two adjacent rows of the detection wire 103 may be 10~12 microns, and the sum of the line width W1 of the detection wire 103 and the first interval distance (that is, the arrangement pitch PI of the detection wire 103) may be 60~80 microns; or, in a case where the sum of the number of first wires 101 and the number of rows of the detection wire 103 is greater than 500 and less than or equal to 2000, the first interval distance D1 between two adjacent rows of the detection wire 103 may be 6~10 microns, and the sum of the line width W1 of the detection wire 103 and the first interval distance D1 (i.e., PI) may be 25~60 microns; or, in a case where the sum of the number of first wires 101 and the number of rows of the detection wire 103 is greater than 2000, the first interval distance D1 between two adjacent rows of the detection wire 103 may be 5~6 microns, and the sum of the line width W1 of the detection wire 103 and the first interval distance D1 (i.e., PI) may be 15~25 microns.

For example, in some embodiments, the second interval distance D2 between two adjacent first wires 101 is the same as the first interval distance D1, and the line width W2 of the first wire 101 is the same as the line width W1 of the detection wire 103, so the sum of the line width W2 of the first wire 101 and the second interval distance D2 (that is, the arrangement pitch P2 of the first wires 101) is the same as the sum of the line width W1 of the detection wire 103 and the first interval distance D1 (i.e., PI).

For example, in some embodiments, in the direction perpendicular to the surface of the display panel, a thickness of the first wire 101 and a thickness of the detection wire 103 are identical, and the thickness is 700 nm~850 nm, such as 750 nm or 800 nm.

For example, in some embodiments, the display panel is in a multi-layer structure, and comprises at least one insulation layer, a conductive pattern layer, etc., the detection wire 101 and at least part of the plurality of first wires 101 are arranged in the same layer, for example, the detection wire 101 and the plurality of first wires are all arranged in the same layer.

Therefore, the structure and arrangement of the plurality of first wires 101 and the structure and arrangement of the detection wire 103 are basically the same, so as to improve the accuracy of determining the state of the first wires 101 based on the detection result of the detection wire 103.

It should be noted that in the embodiments of the present disclosure, "being arranged in the same layer" means that two functional layers or structural layers are formed in the same layer and formed of the same material in the hierarchical structure of the display panel, that is, in the manufacturing process, the two functional layers or structural layers can be formed of the same material layer, and the required patterns and structures can be formed through the same patterning process.

For example, in some embodiments, the display region AA includes a plurality of sub-pixels arranged in an array, each of the plurality of sub-pixels includes a light emitting device and a pixel drive circuit electrically connected to the light emitting device, the pixel drive circuit includes a thin film transistor, the thin film transistor includes a gate electrode and source-drain electrodes, and the detection wire is arranged in the same layer as the gate electrode or in the same layer as the source-drain electrodes.

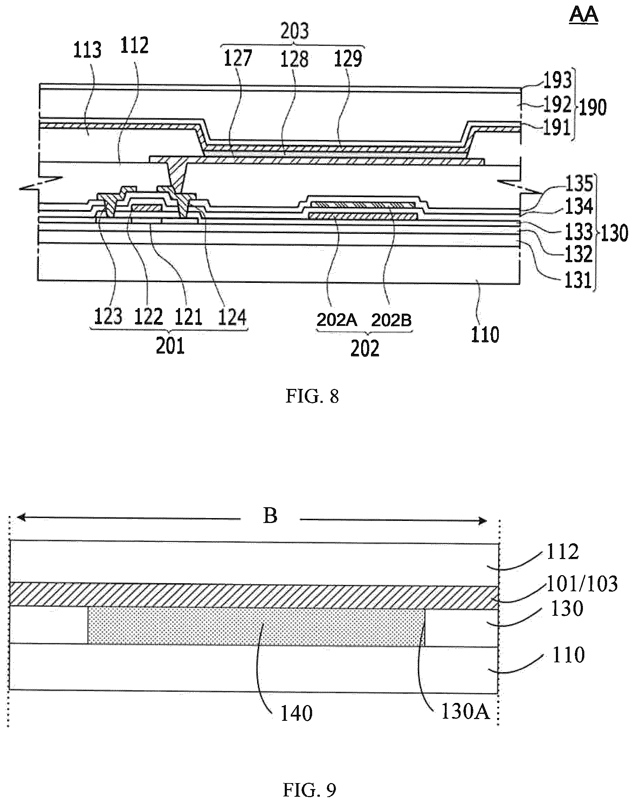

For example, FIG. 8 shows a schematic cross-sectional view of a display region AA of a display panel, and FIG. 9 shows a schematic cross-sectional view of a bending region B of the display panel. As shown in FIG. 8, the display region AA includes a plurality of sub-pixels arranged on the base substrate 110. Each sub-pixel includes a light emitting device 203 and a pixel drive circuit electrically connected to the light emitting device 203, and the pixel drive circuit includes a thin film transistor 201, a storage capacitor 202, and other structures. For example, the thin film transistor 201 includes a semiconductor layer 121, a gate electrode 122, source-drain electrodes (including a source electrode 123 and a drain electrode 124), and the like. The storage capacitor 202 includes a first capacitor plate 202A and a second capacitor plate 202B. For example, the first capacitor plate 202A and the gate electrode 122 are arranged in the same layer. The light emitting device 203 includes an anode 127, a light emitting layer 128, and a cathode 129. For example, the display panel further includes a planarization layer 112 for planarizing the thin film transistor 201 and the storage capacitor 202, the planarization layer 112 has a first via, and the anode 127 of the light emitting device 203 is electrically connected to the drain electrode 124 of the thin film transistor 201 through the first via in the planarization layer 112.

For example, the display region AA further includes insulation layers 130 disposed between different conductive layers. As shown in FIG. 8, the insulation layers 130 include, for example, a barrier layer 131, a buffer layer 132, a gate insulation layer 133, a first interlayer insulation layer 134, and a second interlayer insulation layer 135. The barrier layer 131 and the buffer layer 132 are sequentially disposed on the base substrate 110 to block impurities in the base substrate 110 to prevent the impurities from entering the inside of the display panel. The semiconductor layer 121 is disposed on the buffer layer 132, the gate insulation layer 133 is disposed on the semiconductor layer 121, the gate electrode 122 and the first capacitor plate 202A are disposed on the gate insulation layer 133, and the first interlayer insulation layer 134 is disposed on the gate electrode 122 and the first capacitor plate 202A, the second capacitor plate 202B is disposed on the first interlayer insulation layer 134, the second interlayer insulation layer 135 is disposed on the second capacitor plate 202B, and the source-drain electrodes are disposed on the second interlayer insulation layer 135. For example, the semiconductor layer 121 includes a source region and a drain region, the gate insulation layer 133, the first interlayer insulation layer 134, and the second interlayer insulation layer 135 have second vias exposing the source region and the drain region, and the source electrode 123 and the drain electrode 124 are electrically connected to the source region and the drain region through the second vias, respectively.

For example, the display region AA of the display panel further includes a pixel defining layer 113, an encapsulation layer 190 (including a three-layer structure composed of a first inorganic material layer 191, an organic material layer 192, and a second inorganic material layer 193), and other structures, and the embodiments of the present disclosure are not limited thereto.

For example, as shown in FIG. 3A, the bending region B includes insulation layers 130 disposed on the base substrate 110, and the insulation layers 130 in the bending region B are arranged in the same layer as at least part of the insulation layers 130 in the display region AA, that is, the insulation layers 130 in the bending region B may include one or more selected from a group consisting of the barrier layer 131, the buffer layer 132, the gate insulation layer 133, the first interlayer insulation layer 134, and the second interlayer insulation layer 135. For example, the insulation layers 130 have a groove 130A and a flexible insulation material 140 filled in the groove 130A, and the first wire 101 and the detection wire 103 are disposed on the insulation layers 130.

For example, the flexible insulation material filled in the groove 130A is arranged in the same layer as the planarization layer 112 in the display region AA. For example, the flexible insulation material may be polyimide, resin (for example, acrylic resin, epoxy resin, etc.), or other flexible insulation materials. Because part or all of the insulation layers 130 is formed of inorganic insulation materials, such as silicon nitride, silicon oxide, or silicon oxynitride, etc., because the inorganic insulation materials are usually brittle and are not easy to be bent or break easily after being bent, removing the material of part of the insulation layers 130 in the bending region B and filling the flexible insulation material 140 in the part of the insulation layers 130 can make the bending region B easy to be bent, and the flexible insulation material 140 can play a buffering effect when the bending region B is bent, thereby reducing or preventing the occurrence of fracture due to bending stress.

For example, in some examples, the detection wire 103 may be arranged in the same layer as the source-drain electrodes of the thin film transistor 201 or in the same layer as the gate electrode 122 of the thin film transistor 201. For example, in the embodiments shown in FIG. 3A and FIG. 4, in a case where the first wire 101 is a power line or a data line, the first wire 101 may be arranged in the same layer as the source-drain electrodes of the thin film transistor. In other embodiments, in a case where the first wire 101 is a scan line, the first wire 101 may be arranged in the same layer as the gate electrode 122 of the thin film transistor.

For example, the first wire 101 and the detection wire 103 are arranged in the same layer, that is, the first wire 101 and the detection wire 103 are arranged in the same layer as the source-drain electrodes of the thin film transistor 201 or in the same layer as the gate electrode 122 of the thin film transistor 201, so that the structure and arrangement of the detection wire 103 and the structure and arrangement of the first wire 101 are basically the same.

For example, in the embodiments of the present disclosure, the first wire 101 and the detection wire 103 may be made of metal materials such as copper, aluminum, molybdenum, titanium, or alloy materials, and for example, the first wire 101 and the detection wire 103 may include a single-layer metal structure or a multi-layer metal structure, such as a titanium/aluminum/titanium three-layer metal structure or a molybdenum/aluminum/molybdenum three-layer metal structure, etc. These materials have good ductility and are not easy to break after being bent. For example, the second wire 102, the gate electrode 122, and the source-drain electrodes may also be made of metal materials such as copper, aluminum, molybdenum, and titanium, or alloy materials, for example, the second wire 102, the gate electrode 122, and the source-drain electrodes may include a single-layer metal structure or a multi-layer metal structure. The base substrate 110 may be a flexible substrate to have bending performance, and the material of the flexible substrate may be, for example, polyimide, polyester (PET), polymethyl methacrylate (PMMA), or the like. For example, the semiconductor layer 121 may be an amorphous silicon layer, a polysilicon layer, or a metal oxide semiconductor layer. For example, the polysilicon may be high temperature polysilicon or low temperature polysilicon, and the oxide semiconductor may be indium gallium zinc oxide (IGZO), indium zinc oxide (IZO), zinc oxide (ZnO), gallium zinc oxide (GZO), or the like. For example, one or more of the insulation layers 130 may be made of inorganic insulation materials, such as silicon nitride, silicon oxide, or silicon oxynitride, or made of organic insulation materials, such as resin and the like. The pixel defining layer 113 may adopt organic insulation materials such as resin. The embodiments of the present disclosure do not specifically limit the material of each functional layer.

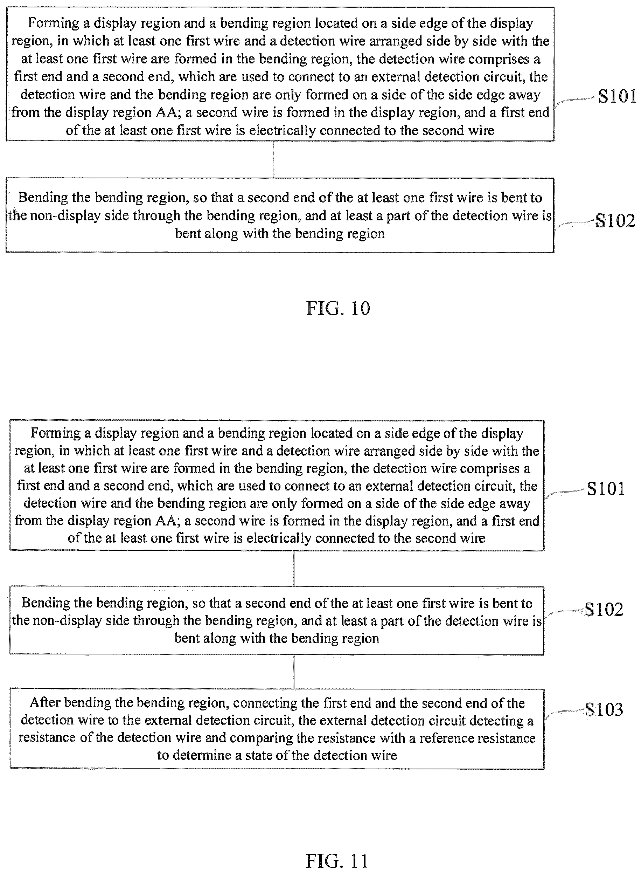

At least one embodiment of the present disclosure further provides a manufacturing method of a display panel, the display panel has a display side and a non-display side, as shown in FIG. 10, the manufacturing method includes steps S101 and S102.

Step S101: forming a display region and a bending region located on a side edge of the display region, in which at least one first wire and a detection wire arranged side by side with the at least one first wire are formed in the bending region, the detection wire comprises a first end and a second end, which are used to connect to an external detection circuit, the detection wire and the bending region are only formed on a side of the side edge away from the display region AA; a second wire is formed in the display region, and a first end of the at least one first wire is electrically connected to the second wire.

For example, in some embodiments, the at least one first wire comprises a plurality of first wires, and the plurality of first wires comprise a first group of wires and a second group of wires, the first group of wires and the second group of wires are insulated from each other and are configured to transmit different electrical signals, respectively, and the detection wire is formed between the first group of wires and the second group of wires. Therefore, the detection wire can avoid signal crosstalk between the first group of wires and the second group of wires, and furthermore prevent the plurality of first wires from causing heat concentration due to transmitting excessive current. The specific settings of the first group of wires and the second group of wires can refer to the above-mentioned embodiments, and will not be repeated here.

For example, in some embodiments, the detection wire is formed in the same layer as at least part of the first wires, for example, the detection wire is formed in the same layer as the plurality of first wires, that is, the detection wire and the plurality of first wires are formed by using the same material layer and using the same patterning process.

For example, in some embodiments, referring to FIG. 8 and FIG. 9, forming the display region further includes forming a plurality of sub-pixels arranged in an array, each of the plurality of sub-pixels includes a light emitting device and a pixel drive circuit electrically connected to the light emitting device, the pixel drive circuit includes a thin film transistor, the thin film transistor includes a gate electrode and source-drain electrodes, and the detection wire is formed in the same layer as the gate electrode or in the same layer as the source-drain electrodes. Therefore, the manufacturing process of the display panel can be simplified.

For example, respective structural layers or functional layers on the display panel can be formed one by one using a patterning process. One patterning process includes, for example, photoresist coating, exposure, development, etching, and so on. For details, reference may be made to related technologies, which are not specifically limited in the embodiments of the present disclosure.

Step S102: bending the bending region, so that a second end of the at least one first wire is bent to the non-display side through the bending region, and at least a part of the detection wire is bent along with the bending region.

For example, the first wire and the detection wire have basically the same structure and arrangement. For details, reference may be made to the foregoing embodiments. Therefore, the first wire and the detection wire have substantially the same bending shape after being bent along with the bending region.

For example, in some embodiments, as shown in FIG. 11, the manufacturing method of the display panel may further include a step S103.

Step S103: after bending the bending region, connecting the first end and the second end of the detection wire to the external detection circuit, the external detection circuit detecting a resistance of the detection wire and comparing the resistance with a reference resistance to determine a state of the detection wire.

For example, in some embodiments, a resistance detection device may be used to detect the resistance of the detection wire. For example, in a case where the difference between the detected resistance of the detection wire and the reference resistance is greater than 10% of the reference resistance, it is determined that the detection wire is in a damaged state, and therefore it can be inferred that the first wire, which is basically in the same structure and arrangement as the detection wire, is also in a damaged state and cannot work normally; for example, in a case where the difference between the resistance and the reference resistance is less than or equal to 10% of the reference resistance, it is determined that the detection wire is in a normal state, and therefore it can be inferred that the first wire, which is basically in the same structure and arrangement as the detection wire, is also in a normal state and can work normally. For example, the above-mentioned reference resistance is an average resistance measured when the detection wire is in a normal state.

As a result, the detection wire in the bending region can be used to determine the state of each wire in the bending region, and then the structure design and the manufacturing process of the bending region can be evaluated, which provides a basis for optimizing the structure design and the manufacturing process of the bending region. Moreover, in a case where the detection wire is formed between the first group of wires and the second group of wires, which are used for transmitting different electrical signals, the detection wire can also avoid signal crosstalk between the first group of wires and the second group of wires, which are used to transmit different electrical signals, and prevent heat concentration due to excessive current transmitted, so as to further improve the display effect of the display panel.

For example, in some embodiments, when it is detected that the detection wire is in a normal state, and it is inferred that the first wire, which is basically in the same structure and arrangement as the detection wire, is also in the normal state, the subsequent manufacturing process, such as an encapsulation process, may be performed on the display panel, and the embodiments of the present disclosure do not limit the subsequent manufacturing processes of the display panel.

The following several statements should be noted:
(1) The accompanying drawings involve only the structure(s) in connection with the embodiment(s) of the present disclosure, and other structure(s) can be referred to common design(s).
(2) For clarity, in accompanying drawings for illustrating the embodiment(s) of the present disclosure, the thickness of a layer or a structure may be enlarged or reduced. However, it should understood that, in the case in which a component or element such as a layer, film, area, substrate or the like is referred to be "on" or "under" another component or element, it may be directly on or under the another component or element or a component or element is interposed therebetween.
(3) In case of no conflict, embodiments of the present disclosure and the features in the embodiments may be mutually combined to obtain new embodiments.

The above descriptions are only specific embodiments of the present disclosure, but the protection scope of the present disclosure is not limited thereto, the protection scope of the present disclosure should be determined by the protection scope of the claims.

## Claims

1. A display panel, having a display side and a non-display side, and comprising a display region and a bending region located on a side edge of the display region,
wherein the bending region comprises at least one first wire, and the bending region is capable of being operatively bent from the display side to the non-display side,
the display region comprises a second wire, a first end of the at least one first wire is electrically connected to the second wire, and a second end of the at least one first wire is bent to the non-display side through the bending region;
the bending region further comprises a detection wire arranged side by side with the at least one first wire, at least a part of the detection wire is bent along with the bending region, and the detection wire comprises a first end and a second end, which are used to connect an external detection circuit; and the detection wire and the bending region are only located on a side of the side edge away from the display region.

2. The display panel according to claim 1, wherein the at least one first wire comprises a plurality of first wires, and the plurality of first wires comprise a first group of wires and a second group of wires, the first group of wires and the second group of wires are insulated from each other and are configured to transmit different electrical signals, respectively,
the detection wire is arranged between the first group of wires and the second group of wires.

3. The display panel according to claim 2, wherein the first group of wires are power wires, and the second group of wires are data wires; or
the first group of wires and the second group of wires are power wires that transmit different potentials.

4. The display panel according to any one of claims 1 to 3, wherein a shape and a size of the first wire per unit length are substantially identical to a shape and a size of the detection wire per unit length.

5. The display panel according to claim 4, wherein both the first wire and the detection wire extend in a curved shape or have a hollow structure.

6. The display panel according to any one of claims 1 to 5, wherein the detection wire is arranged in a plurality of rows that are electrically connected in an end-to-end manner in sequence, and the first end and the second end of the detection wire are respectively located in a first row and a last row of the plurality of rows.

7. The display panel according to any one of claims 1 to 6, wherein after the bending region is bent, the first end and the second end of the detection wire are both located on the non-display side.

8. The display panel according to claim 6 or 7, wherein in the bending region,
a sum of a count of first wires and a count of the rows of the detection wire is less than or equal to 500, a first interval distance between two adjacent rows of the detection wire is 10~12 microns, and a sum of a line width of the detection wire and the first interval distance is 60~80 microns; or
a sum of a count of first wires and a count of the rows of the detection wire is greater than 500 and is less than or equal to 2000, a first interval distance between two adjacent rows of the detection wire is 6~10 microns, and a sum of a line width of the detection wire and the first interval distance is 25~60 microns; or
a sum of a count of first wires and a count of the rows of the detection wire is greater than 2000, a first interval distance between two adjacent rows of the detection wire is 5~6 microns, and a sum of a line width of the detection wire and the first interval distance is 15~25 microns.

9. The display panel according to claim 8, wherein a second interval distance between two adjacent first wires is identical to the first interval distance, and a sum of a line width of the first wire and the second interval distance is identical to the sum of the line width of the detection wire and the first interval distance.

10. The display panel according to any one of claims 1 to 9, wherein in a direction perpendicular to a surface of the display panel, a thickness of the first wire and a thickness of the detection wire are identical, and the thickness is 700 nm~850 nm.

11. The display panel according to claim 2 or 3, wherein the detection wire and at least part of the plurality of first wires are arranged in a same layer.

12. The display panel according to claim 11, wherein the display region comprises a plurality of sub-pixels arranged in an array, each of the plurality of sub-pixels comprises a light emitting device and a pixel drive circuit electrically connected to the light emitting device, the pixel drive circuit comprises a thin film transistor, and the thin film transistor comprises a gate electrode and source-drain electrodes,
the detection wire is arranged in a same layer as the gate electrode or arranged in a same layer as the source-drain electrodes.

13. A manufacturing method of a display panel, the display panel having a display side and a non-display side, the method comprising:
forming a display region and a bending region located on a side edge of the display region, wherein at least one first wire and a detection wire arranged side by side with the at least one first wire are formed in the bending region, the detection wire comprises a first end and a second end, which are used to connect an external detection circuit, the detection wire and the bending region are only formed on a side of the side edge away from the display region; a second wire is formed in the display region, and a first end of the at least one first wire is electrically connected to the second wire; and
bending the bending region, so that a second end of the at least one first wire is bent to the non-display side through the bending region, and at least a part of the detection wire is bent along with the bending region.

14. The manufacturing method according to claim 13, further comprising: after bending the bending region, connecting the first end and the second end of the detection wire to the external detection circuit, the external detection circuit detecting a resistance of the detection wire and comparing the resistance with a reference resistance to determine a state of the detection wire.

15. The manufacturing method according to claim 14, wherein in a case where a difference between the resistance and the reference resistance is greater than ten percent of the reference resistance, it is determined that the detection wire is in a damaged state; and
in a case where the difference between the resistance and the reference resistance is less than or equal to ten percent of the reference resistance, it is determined that the detection wire is in a normal state.

16. The manufacturing method according to any one of claims 13-15, wherein the at least one first wire comprises a plurality of first wires, and the plurality of first wires comprise a first group of wires and a second group of wires, the first group of wires and the second group of wires are insulated from each other and are configured to transmit different electrical signals, respectively,
the detection wire is formed between the first group of wires and the second group of wires.

17. The manufacturing method according to claim 16, wherein the detection wire and at least part of the plurality of first wires are formed in a same layer.

18. The manufacturing method according to claim 17, wherein forming the display region further comprises forming a plurality of sub-pixels arranged in an array, each of the plurality of sub-pixels comprising a light emitting device and a pixel drive circuit electrically connected to the light emitting device, the pixel drive circuit comprising a thin film transistor, and the thin film transistor comprising a gate electrode and source-drain electrodes,
the detection wire is formed in a same layer as the gate electrode or formed in a same layer as the source-drain electrodes.
